# EUROPEAN PATENT APPLICATION

(11) **EP 1 605 502 A1**
(43) Date of publication of application: **14.12.2005**
(21) Application number: 04447140.7
(22) Date of filing: 08.06.2004
(51) Int. Cl.: H01L 21/68

(54) **Transfer method for the manufacturing of electronic devices**

(71) Applicant: INTERUNIVERSITAIR MICROELEKTRONICA CENTRUM VZW, 3001 Leuven (BE); Umicore N.V., 1000 Bruxelles (BE)
(72) Inventor: Flamand, Giovanni, 2110 Wijnegem (BE); Greens, Wim, 2800 Mechelen (BE)
(74) Representative: Van Malderen, Joelle

(57) **Abstract**

The present invention is related to a method for the manufacture of an electronic device comprising the steps of:
a. releasably bonding a processable substrate to a face of a first carrier substrate (2) by means of a first bonding agent (4), thereby obtaining a first composite substrate;
b. processing the processable substrate of the first composite substrate so as to manufacture an electronic device comprised on its surface; and
c. releasing the processable substrate from the first carrier substrate (2) by a releasing agent (8);
   whereby the face of the first carrier substrate comprises a pattern of trenches (3).

## Description

### Field of the invention

The present invention relates to the field of microelectronic device manufacturing and corresponding devices and structures. It concerns in particular the production of thin processable semiconductor substrates, which can be used in photovoltaic solar cell manufacturing.

### Background of the invention

The power requirements for space solar arrays are continually increasing, which makes an increase in operating voltage desirable, mainly because of indirect effects leading to a reduction in spacecraft mass.

However, with an increase in array voltage, the likelihood increases of solar cell array degradation due to arcing in the plasma-prone spacecraft environment. The next generation of array technologies should therefore aim at higher operating voltages and at reduced arcing propensity.

One possible approach is to reduce the overall number of electrical connections exposed to the environment by incorporating the solar cell series connections under a cover glass, thereby forming integrated high voltage modules (HVM). In addition, if the cover glass could be used as a superstrate for the underlying module, the module could potentially be made thinner, resulting in and a significant reduction in mass. In the context of existing III-V multi-junction technology on germanium, the active photovoltaic layers represent only a few microns of material grown on the surface of a germanium substrate, which is typically around 140 *µ*m thick. Consequently, the successful implementation of high voltage, integrated multi-junction solar cell modules on thin germanium based substrates can bring considerable performance and cost benefits.

Outside of the field of spacecraft power generation and germanium solar cells, much effort is put into developing technologies, which allow the production of thin, high quality semiconductor substrates. Many applications require only a thin layer of semiconductor as structural or functional part, while often, only thick substrates are available. Thinning such substrates and handling them efficiently and without creating damage is however far from evident.

Thinner substrates offer different advantages such as weight reduction and cost reduction, in particular for relatively expensive substrates such as germanium substrates.

In US 2002/0190269 A1, a method is disclosed providing a heterogeneous structure of a thin germanium film on a silicon substrate for photovoltaic applications. However, only very thin film of about 1 *µ*m can be produced, so that mechanical support is required before further processing is possible. The film is therefore directly and permanently bonded on a silicon carrier substrate. Further processing possibilities are limited. For instance, an MOCVD process step would not be feasible because of the large difference in thermal expansion coefficient between the silicon substrate and the germanium film. Moreover, such thin films are not suited for typical solar cell applications.

### Aim of the invention

It is an aim of this invention to provide for a method for producing processable substrates with a reduced thickness, which alleviates or avoids the problems of the prior art. It is a further aim to provide a method for handling such processable semiconductor substrates. Still another aim of the present invention is to apply the invented methods for the production of high voltage modules (HVM).

### Summary of the invention

A method for the manufacture of an electronic device is disclosed comprising the steps of:
- releasably bonding a processable substrate to a face of a first carrier substrate, by means of a first bonding agent, thereby obtaining a first composite substrate;
- processing the processable substrate of the first composite substrate so as to manufacture an electronic device comprised on its surface; and
- releasing the processable substrate from the first carrier substrate by means of a releasing agent; whereby the face of the first carrier substrate comprises a pattern of trenches.

In a first aspect of the present invention, the processable substrate and the first carrier substrate can comprise different or identical constituent materials, such as germanium, silicon, GaAs, and alumina. They can have different shapes. Typical commercially available substrates are circular discs but nothing limits the present invention to this particular geometry. Advantageously, the bonding surfaces of the substrates should be as flat as possible, while the shape of the edge sidewalls of the substrates is less important.

The trenches in the first carrier substrate can be made by different state of the art techniques as for instance dry etching or wet etching.

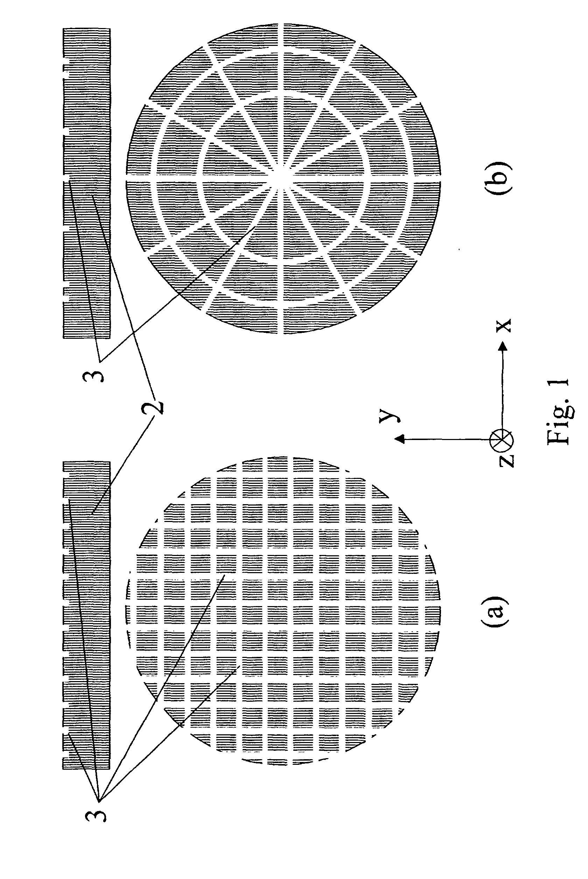

They can be made according to different patterns as illustrated in Fig. 1. For instance, a lattice pattern with grid lines in the x and y directions, whereby the x and y axis are defined as being orthogonally positioned or inclined with respect to each other and lying in the substrate surface plane. The lattice constants in the x and y directions are not necessarily equal. Varying grid line distances is also possible, as is random patterning. In a preferred embodiment, the edges of the processable substrate and the first carrier substrate define the same shape in the surface plane. Depending on this shape, certain geometric configurations can be advantageously used. For circular shaped substrates the pattern can comprise a set of regularly spaced diagonal lines.

The importance of the trenches and their specific pattern in the context of the present disclosure can be found when considering bonding and releasing aspects.

For the step of releasably bonding a processable substrate to a carrier substrate by means of a first bonding agent, a lot of factors have to be considered apart from finding appropriate substrates and bonding agents and finding methods for applying and removing the bonding agent. Moreover different substrate treatments may be necessary. The method and corresponding devices according to the present invention provide a way to facilitate the bond to be released.

According to preferred embodiments of the present invention, the bonded processable substrate undergoes also a thinning step, of which already some of the advantages are described in the state of the art section. This step can for instance be performed by grinding or Chemical Mechanical Polishing (CMP). Common to these methods is that they apply a mechanical force on the processable substrate and composite substrate, which can severely impact its quality or even destroy it. Therefore, the bonding agent has to provide both mechanical stability and support to the processable substrate to allow its successful thinning.

Moreover, according to the present invention, the bonded processable substrate undergoes processing while bonded, thereby undergoing rather severe conditions of atmosphere, pressure and temperature. Therefore, the bonding agent needs to be chosen such that it does not deteriorate or otherwise interfere during processing, and such that, after processing, an efficient removal of the bonding agent is possible. Preferably, the maximum temperature which can be withstood by the bonding agent is higher then the maximum temperature reached by the processable substrate and first carrier substrate during processing.

A preferred property of combinations of these substrates and bonding agent is that they have a closely matched or compatible thermal expansion coefficient.

Another factor is the application of the bonding agent, which requires good application properties and for which removal methods, comprising the use of a releasing agent, must exist. It has to adhere sufficiently well to both the processable substrate and the first carrier substrate. Moreover it is preferably applicable such that the trenches in the first carrier substrate are not being filled up. The bonding agent can be applied on either one or both of (i.) a face of the processable substrate and (ii.) the face comprising trenches of the first carrier substrate, whereby the trenches are not or not completely filled or in other words such that the trenches are at least partially free of bonding agent after bonding. When the bonding agent is applied on (i) a side of the processable substrate, care should be taken in the amount and properties of this bonding agent such that the trenches in the first carrier substrate do not become filled or closed locally during the further steps according to the present invention which are preceding the releasing step.

The use of trenches on the first carrier substrate, which stay empty or at least partially empty during the bonding step and up to the releasing step according to the present invention, allows the releasing agent to reach the bonding agent more easily. The releasing agent can propagate into and is guided by the trenches and interact with the bonding agent, for instance it can etch or solve the bonding agent or embrittle it.

Therefore the method and corresponding devices according to the present invention provide a way to at least facilitate the bond to be released.

The shape of the lattice of trenches and the trench dimensions themselves are factors that influence the releasability and rate of release.

The trenches can additionally allow solvents or other products produced during bonding, such as gasses which can form bubbles, to be evacuated. Solvents can indeed be present in certain bonding agents when they are to be applied. It has been found that the formation of bubbles in the bonding agent jeopardises the thinning step, as, in combination with mechanical pressure, they cause cracks to appear thereby destroying the processable substrate.

In embodiments according to the present invention whereby a thinning step is applied, the processable substrate typically has a thickness of more then 50 *µ*m before, and of less then 50 *µ*m after thinning. The processable substrate can be thinned to less then 80 *µ*m, 70 *µ*m, 60 *µ*m, 50 *µ*m, and typically to less then 40 *µ*m, 35 *µ*m, 30 *µ*m, 25 *µ*m, 20 *µ*m, 15 *µ*m, 10 *µ*m or 5 *µ*m. Practically any substrate starting thickness can be used. The thinning of the processable substrate is often an industrial or commercial requirement, some advantages of which were already discussed in the background chapter. The thinning of the processable substrate can bring further advantages when producing a device requiring device the production of through holes and/or separation channels. A through hole is a hole connecting the front side to the back side of a substrate. Its cross-section along the longitudinal direction can have any shape and can vary depending on the position in the hole. Typically, such a cross-section is circular or elliptic. Any other shape is also possible. These through holes and optional corresponding electrical interconnects, can be made efficiently, deep and narrow enough, with state of the art techniques for a substrate thickness up to 50 *µ*m, preferably up to 40 *µ*m. This can for instance be done by a step of dry or wet etching. Those steps can be performed while processing the processable substrate. Etching through thicker layers is more difficult since it requires a strong selectivity of the etching process with respect to the masking resist layer, which should not be etched away. The etching process would in case of thicker substrates also take more time, which would increase cost and decrease yield. Isolation of the sidewalls of deeper holes for instance by applying BCB (benzocyclobutene) and the application of metallisation in the through holes also become more difficult.

The device produced on the processable substrate can be a solar cell. Further advantages with respect to individual solar cells, solar cells arrays or HVM, especially for space-applications, are explained below.

Current commercial processable substrates typically have a thickness of 90 *µ*m or more.

In preferred embodiments, the bonding agent according to the present invention is spin-on glass (SOG). Advantageously certain spin-on glasses can be used when working with a germanium substrate and germanium carrier substrate, since the thermal expansion coefficient (TEC) of spin-on glass and germanium can be closely matched. Examples of spin-on glasses with a TEC closely matched to the TEC of germanium (6.10⁻⁶ K⁻¹) are e.g. Accuglass 311®, Accuglass 512B® (Honeywell) and spin-on glasses 200F and 550F (Filmtronics), all having a TEC of approximately 5.10⁻⁶ K⁻¹.

In general, the TEC of the bonding agent differs preferably not more then 50%, more preferably not more then 20%, from the TECs of the first carrier substrate and processable substrate.

Other combinations of material sets can be envisaged for the processable substrate, the first carrier substrate, the first bonding agent and the releasing agent, such as, respectively, silicon, silicon, spin-on glass with compatible TEC, HF, or, silicon, GaAs, spin-on glass with compatible TEC, HF.

Appropriate releasing agents for the spin-on glass bonding agent are HF (hydrofluoric acid) or and BHF (buffered hydrofluoric acid). They can be applied in liquid of gaseous phase, and can be either pure or diluted with water.

The choice of materials for the processable substrate, carrier substrate(s) and bonding agent(s) should allow for the selective removal of the first bonding agent, e.g. by etching. If selective removal of this bonding agent is not possible, supplementary steps, such as masking steps, should be included so as to adequately protect the substrates or the other bonding agents.

In preferred embodiments, using spin-on glass as a bonding agent, the bonding step according to the present invention comprises the steps of:
- applying a quantity of a bonding agent on one or both of (i.) a face of the processable substrate and (ii.) the face comprising trenches of the first carrier substrate (as discussed before)
- pressing the processable substrate and the first carrier substrate against each other, with the spin-on glass in between; and
- applying a heat step to the composite substrate, optionally while exercising a mechanical pressure on the composite substrate.

In a further aspect of the present invention the methods described before can further comprise a step comprising the bonding of the processed substrate to a second carrier substrate by means of a second bonding agent (thereby obtaining a second composite substrate) between the steps of processing the processable substrate and releasing the first carrier substrate.

This solution can be particularly interesting for space applications where the weight of devices such as solar cells, produced on the processable substrate, should maximally be reduced. In such methods, the second bonding agent should further be space qualified or space qualifyable (e.g. conformal to the ESA specification ESSC 12100 (Issue 2, July 2003), "Procedure for Qualifications" or to the NASA specification NASA SP-8044 "Qualification Testing" or similar). It can be e.g. a space-qualified sealant like Dow Corning® 93-500 space grade encapsulant. The second carrier substrate can be light, cheap and/or transparent for wavelengths according to the application envisaged. For solar cell applications, the material could advantageously be chosen transparent for sunlight, thin, strong, and generally of high quality. It could furthermore provide for additional functionality. It could for instance be glass.

In the context of high voltage devices as for instance HVM solar cells, particularly for space applications, the problem of arcing has to be dealt with. Therefore, if the processable substrate is further processed towards a solar cell device, the processed substrate can be divided in separate substrate parts, resulting in an array of separate solar cell devices, which can be electrically interconnected by making use separation channels or through holes. This is preferably combined with embodiments where the processable substrate is thinned. In the presence of separation channels or through holes, the respective techniques of 'wrap-around' or 'wrap-through' can be used for the electrical interconnection. This can be performed by producing separation channels using mechanical or chemical means like the dry etching processes (e.g. RIE, ICP, plasma etching) and the wet etching processes. By doing so, the generated current per solar cell surface area remains essentially the same, while the average voltage is multiplied by the number of solar cells in series. The separation channels offer moreover the possibility of integrating bypass diodes. The second bonding agent can provide mechanical stability under temperature changes, or can provide a degree of flexibility to the substrate, making it less sensitive to mechanical stress.

The second carrier substrate, often named superstrate, forms a barrier between the devices, such as solar cells including electrical interconnections, and the surrounding environment. This barrier effectively protects the devices from the arcing phenomena that tend to occur in the plasma-prone environment encountered in space, in particular in the vicinity of a spacecraft.

In a first type of device according to embodiments of the present invention, a composite substrate comprising a processable substrate releasably bonded by means of a first bonding agent to a first carrier substrate is disclosed, the first carrier substrate comprising trenches at the bonding interface.

In preferred embodiments, the first bonding agent, the processable substrate and the first carrier substrate have a compatible, similar or closely matched thermal expansion coefficient. In typical embodiments, ready for further processing, the processable substrate has a thickness of less than 90 *µ*m. Alternatively, the thickness can be less then 80 *µ*m, 70 *µ*m, 60 *µ*m, 50 *µ*m, 40 *µ*m, 35 *µ*m, 30 *µ*m, 25 *µ*m, 20 *µ*m, 15 *µ*m, 10 *µ*m or 5 *µ*m. The minimum thickness is essentially determined by the flatness of the bonding interface. There is only a practical limitation on the upper limit of the thickness.

In preferred embodiments, the bonding interface comprises spin-on glass and the trenches in the carrier substrate are at least partially free of bonding agent.

In preferred embodiments, the processable substrate and/or the first carrier substrate are germanium substrates.

In preferred embodiments, an electronic device is manufactured on the surface of the processable substrate. This electronic device can be a solar cell, a Light Emitting Diode, a CMOS circuit or any device achievable by semiconductor processing.

In other embodiments, according to a second type of device according to the present invention, a composite substrate is disclosed, comprising at least one electronic device comprised on the surface of a processed substrate with a thickness of more than 10 *µ*m and less than 90 *µ*m, the substrate being bonded by means of a second bonding agent to a second carrier substrate. The thickness of the processed substrate can be less then 90 *µ*m, 80 *µ*m, 70*µ*m, 60*µ*m, 50*µ*m, 40*µ*m, 35 *µ*m, 30 *µ*m, 25 *µ*m, 20 *µ*m or 15*µ*m.

In preferred embodiment the second bonding agent comprises a space qualified or space qualifyable sealant (for instance conformal to the ESA specification ESSC 12100, Issue 2, July 2003, "Procedure for Qualifications" or to the NASA specification NASA SP-8044 "Qualification Testing" or similar).

In other embodiments, the processed substrate comprises at least 1 through hole or separation channel.

In preferred embodiment, the second carrier substrate is transparent, i.e. has the property of transmitting light for wavelengths dependent on the application aimed at. For instance, this can be transparent for sunlight for solar cell applications). This second carrier substrate can for instance be glass.

In preferred embodiments, the processable substrate comprises at least one solar cell or multiple solar cells on its surface. In such preferred embodiments, the solar cells can be multi-junction solar cells, which can comprise a germanium junction. The cells are preferably series connected.

In preferred embodiments, the processable substrate is a germanium substrate and the second carrier substrate is glass.

### Description of the figures

Fig. 1 (a) and (b) shows some examples of patterns of trenches (3) provided on the first carrier substrate (2).

In Fig. 2, the first bonding agent (4) is present between the first carrier substrate (2), comprising trenches (3) and the processable substrate. This is applied such that the trenches are at least partially free of bonding agent after bonding.

Fig. 3 illustrates an embodiment of the present invention in which through holes or separation trenches are provided in the processable substrate, the latter having been thinned in a previous step. These separation trenches or through holes can then be used for electrical interconnects (5).

Fig. 4 illustrates a device according to Fig. 3, which is further bonded to a second carrier substrate (7) by means of a second bonding agent (6).

In Fig. 5, the release step is being illustrated. The releasing agent (8) is gradually penetrating the trenches (3), reaches the bonding agent (4) thereby releasing the processed substrate from the first carrier substrate.

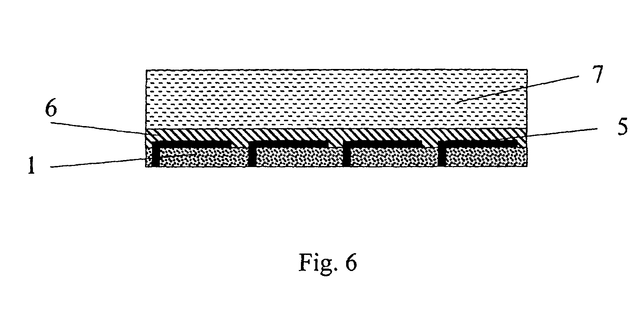

The resulting device according to embodiments of the present invention is depicted in Fig. 6.

### Detailed description of the invention

The present invention is described in detail below. It is apparent, however, that a person skilled in the art can imagine several other equivalent embodiments or other ways of executing the present invention, the spirit and scope of the present invention being limited only by the terms of the appended claims.

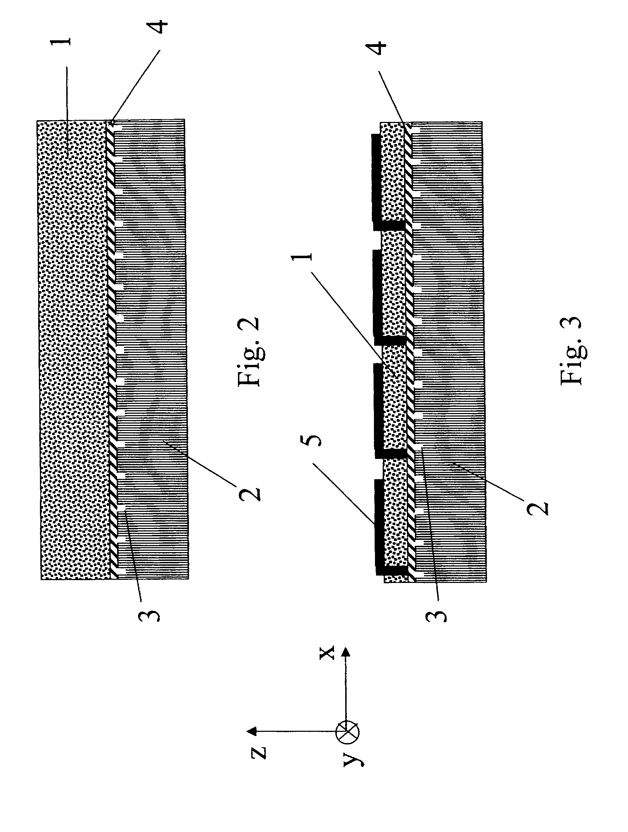

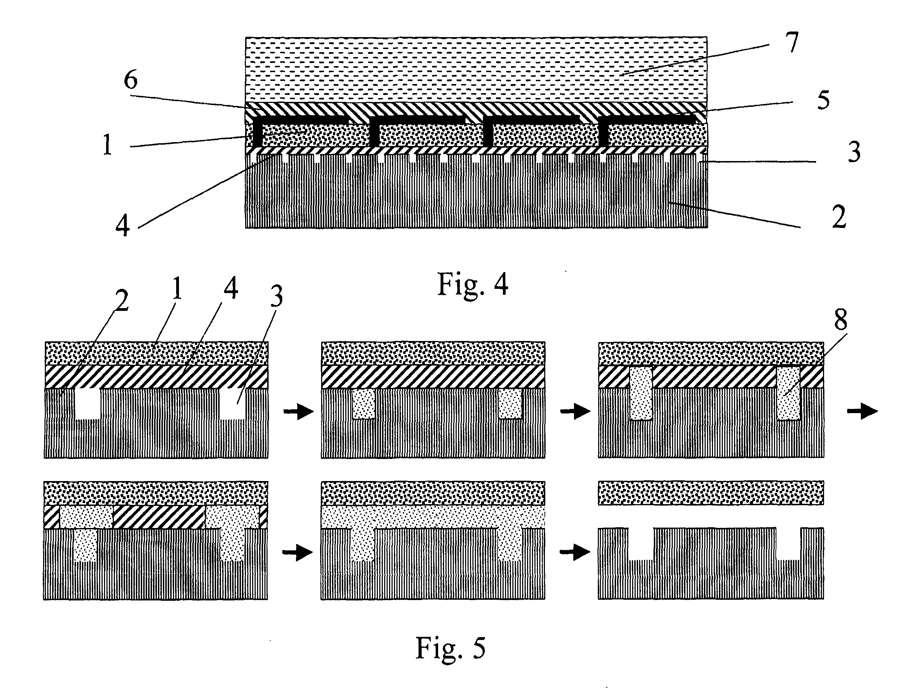

The following steps are typically performed.
Step 1: a carrier substrate, preferably a germanium substrate, is prepared by realising a pattern of trenches on its face. Different trench patterns, e.g. grid lines in x and y directions or a mix of diagonal lines and concentric circles, can be used (Fig. 1). The trenches can be made by a conventional dry or wet etching step, after definition of the trench pattern by conventional lithography.
Step 2: a germanium substrate is bonded to the above-mentioned carrier substrate by application of a bonding agent to a face of the substrate and possibly also to the trench patterned face of the carrier substrate and by pressing the substrate and carrier substrate together with the bonding agent in between. The substrate and carrier substrate are positioned such that the bonded face of the carrier substrate is the trench-patterned face, and the thickness of the bonding agent is such that it does not fill the trenches in the carrier substrate (Fig. 2). Preferably, the bonding agent is a spin-on glass with a TEC closely matched to the TEC of the substrate and carrier substrate. This SOG is deposited on the face of the substrate and possibly also on the trench patterned face of the carrier substrate, thereby applying a convenient amount of the SOG and distributing it evenly by spinning the substrate(s). The spinning is performed between 1000 and 5000 rpm for 10 s to 120 s, preferably at 2000 rpm for 30 s.
   The SOG bonding agent is cured by a heat step between 300 °C and 600 °C, during 10 min to 120 min. Preferably, the curing temperature is chosen between 400°C and 450 °C, and the duration is approximately 60 min. This temperature step is performed in nitrogen. Other curing environments are possible, as for instance air, forming gas or hydrogen.
Step 3: the substrate, bonded to the carrier substrate, is thinned to the desired thickness. This can be performed using a state-of-the-art technique as grinding, polishing, dry etching, wet etching, or a combination of these methods.
Step 4: once the substrate has been thinned to the desired thickness, all relevant processing steps are performed in order to build one or more electronic components in and/or on the substrate. These steps can comprise e.g. epitaxial deposition on the substrate, wet/dry etching of the substrate, diffusion of dopants into the substrate and deposition/annealing of contacting layers onto the substrate (Fig. 3). These may also include etching of through holes completely through the substrate, and filling of these through holes with metallisation. The latter steps are strongly facilitated by the reduced thickness of the substrate.
Step 5: when the front side processing of the devices is finished, a second carrier substrate or superstrate can be bonded to the substrate by means of a second bonding agent. This bonding agent can be for Dow Corning® 93-500 or other silicone sealant/cement such as BCB. This second carrier substrate should be transparent when the upper part of the processed substrate needs to be optically reachable, as is the case for solar cells; it can be e.g. glass (Fig. 4).
Step 6: the first carrier substrate is released from the structure by selectively etching the first bonding layer, which is SOG. This can be performed by immersion in a wet etchant with a strong selectivity in etching of SOG with respect to germanium. This will preferably be a diluted HF or BHF solution. These have been shown to etch SOG materials with an etch rate which is 3 to 5 orders of magnitude above the etch rate of germanium in these solutions. The presence of the trench pattern in the first carrier substrate facilitates transport of the etchant over the whole area of the bonding layer, resulting in a homogeneous etching over the area of the bonding layer and a release of the first carrier substrate within 1 to 30 min (see Fig. 5).
Step 7: the substrate and the devices fabricated on or in it can be further processed from the back side of the substrate, while the substrate is now mechanically supported by the second carrier substrate (see Fig. 6).

### Example of practical realisation of the invention

A 500 *µ*m thick 4 inch (10 cm) germanium carrier substrate is prepared by realising a grid-shaped trench pattern on its side. The trenches have a channel width of 20 *µ*m, and an inter-channel spacing of 460 *µ*m. This pattern, defined by conventional lithographic, is etched my means of dry etching using a RIE (Reactive Ion Etching) machine. The depth of the trenches is 15 *µ*m. A 90 *µ*m thick, 4 inch (10 cm) germanium substrate is bonded to the above-mentioned carrier substrate, using Filmtronics 550F spin-on glass. The SOG is applied to the face of this germanium substrate, by pipetting 4 ml of the SOG on this face, and subsequently spreading the SOG over the area of this substrate by spinning the wafer at 2000 rpm for 30 sec. This results in a uniform layer of SOG with an approximate thickness of 700 nm. The germanium substrate and the carrier substrate are positioned over each other, with respectively the SOG containing face and the face comprising the trench pattern facing each other, and both substrates are manually pressed together. This wafer pair is then placed in an oven to perform curing of the spin-on glass. Curing is performed in nitrogen, at a temperature of 425 °C, for a period of 1 hour.
Bonded wafer pairs with a total thickness variation (TTV) lower than 10 *µ*m have been realised.
Bonding of 90 *µ*m wafers with a polished surface as well as with a ground and chemically etched surface could be established.
Thinning of the bonded 90 *µ*m germanium wafer was done by a combination of diamond grinding and polishing. A grinding wheel with a grit size of #1700 is used to remove approximately 40 *µ*m of material. As a next step, a chemical mechanical polishing process is implemented to remove an additional 30 *µ*m of material in order to reach the final thickness of approximately 20 *µ*m.

## Claims

1. Method for the manufacture of an electronic device comprising the steps of:
a. releasably bonding a processable substrate to a face of a first carrier substrate by means of a first bonding agent, thereby obtaining a first composite substrate;
b. processing the processable substrate of the first composite substrate so as to manufacture an electronic device comprised on its surface; and
c. releasing the processable substrate from the first carrier substrate by a releasing agent;
whereby said face of the first carrier substrate comprises a pattern of trenches.

2. Method according to claim 1, further comprising a step of thinning the processable substrate of the first composite substrate after the bonding step and before the processing step.

3. Method according to claim 2, whereby the processable substrate has a thickness of at least 50 *µ*m before thinning and of less than 50 *µ*m after thinning.

4. Method according to claims 1 to 3, whereby the step of releasably bonding a processable substrate comprises the steps of:
a. applying a quantity of said first bonding agent on either one or both of (i.) a face of the processable substrate and (ii.) said face comprising trenches of the first carrier substrate, such that the trenches are at least partially free of bonding agent after bonding;
b. pressing the processable substrate and the first carrier substrate against each other, with the bonding agent in between; and
c. applying a heat step to the composite substrate, optionally while exercising a mechanical pressure on the composite substrate.

5. Method according to claim 4, whereby the first bonding agent, the processable substrate and the first carrier substrate have a compatible thermal expansion coefficient.

6. Method according to any one of claims 1 to 5, whereby a step comprising the bonding of the processable substrate to a second carrier substrate by means of a second bonding agent is inserted between the steps of processing and releasing the processable substrate, thereby obtaining a second composite substrate.

7. Method according to claim 6, whereby said second bonding agent is a space qualified or space qualifyable sealant.

8. Method according to claims 6 or 7, whereby the second carrier substrate is transparent.

9. Method according to claim 8, whereby the second carrier substrate comprises glass.

10. Method according to any one of claims 1 to 9, whereby the step of processing the processable substrate comprises a step of etching holes or trenches in said substrate by dry etching.

11. Method according to any one of claims 1 to 10, whereby the step of processing the processable substrate comprises a step of separating it into separated substrate parts by providing channels using mechanical or chemical means.

12. Method according to claim 11, whereby the separated substrate parts are electrically interconnected.

13. Method according to claim 1 to 12, whereby the first bonding agent comprises spin-on glass.

14. Method according to claim 13, whereby HF is used as a releasing agent in the step of releasing the processable substrate.

15. Method according to any of claims 1 to 14, whereby the processable substrate and the first carrier substrate are germanium substrates.

16. A composite substrate comprising a processable substrate releasably bonded by means of a first bonding agent to a first carrier substrate comprising a pattern of trenches at the bonding interface.

17. A composite substrate according to claim 16, whereby the first bonding agent, the processable substrate and the first carrier substrate have a compatible thermal expansion coefficient.

18. A composite substrate according to claim 17, whereby the processable substrate has a thickness of less than 90 *µ*m.

19. A composite substrate according to claim 18, whereby the processable substrate has a thickness of less than 40 *µ*m.

20. A composite substrate according to any one of claims 16 to 19, whereby the first bonding agent comprises spin-on glass and whereby the trenches are at least partially free of bonding agent.

21. A composite substrate according to any of claims 16 to 20, whereby the processable substrate and the first carrier substrate are germanium substrates.

22. An electronic device, comprised on the front side of a processable substrate, the back side of said substrate being releasably bonded by means of a first bonding agent to a first carrier substrate comprising a pattern of trenches at the bonding interface.

23. An electronic device according to claim 22, comprising one or more items from the list consisting of a solar cell, a Light Emitting Diode, and a CMOS circuit.

24. An electronic device according to claim 22 to 23, whereby the first bonding agent, the processable substrate and the first carrier substrate have a compatible thermal expansion coefficient.

25. An electronic device according to any of claims 22 to 24, whereby the processable substrate and the first carrier substrate are germanium substrates.

26. An electronic device, comprised on the front side of a processable substrate with a thickness of more than 10 *µ*m and less than 90 *µ*m, the front side of the substrate being bonded by means of a second bonding agent to a second carrier substrate.

27. An electronic device according to claim 26, whereby the processable substrate has a thickness of less than 40 *µ*m.

28. An electronic device according to claims 26 to 27, whereby the second bonding agent comprises a space qualified or space qualifiable sealant.

29. An electronic device according to any one of claims 26 to 28, whereby the processable substrate comprises at least one through hole or separation channel.

30. An electronic device according to any one of claims 26 to 29, whereby the second carrier substrate is transparent.

31. An electronic device according to claim 30, whereby the second carrier substrate comprises glass.

32. An electronic device according to any one of claims 26 to 31, whereby the processable substrate comprises at least one solar cell on its front side.

33. An electronic device according to claim 32, whereby the processable substrate comprises multiple solar cells on its front side.

34. An electronic device according to claim 33, whereby the multiple solar cells are series connected.

35. An electronic device according to any one of claim 26 to 34, whereby the processable substrate is a germanium substrate.

36. An electronic device according to claim 32 to 35, whereby said solar cell is a multi-junction solar cell, said multi-junction solar cell including a germanium junction.
